# EUROPEAN PATENT APPLICATION

(11) **EP 3 264 454 A1**
(43) Date of publication of application: **03.01.2018**
(21) Application number: 16197024.9
(22) Date of filing: 03.11.2016
(51) Int. Cl.: H01L 23/29, H01L 23/31

(54) **POWER MODULE AND METHOD OF MANUFACTURING THE SAME**

(30) Priority: 29.06.2016 KR 20160081905
(71) Applicant: Hyundai Motor Company, Seoul 137-938 (KR)
(72) Inventor: Son, Jeong Min, 13626 Gyeonggi-do (KR); Park, Sung Won, 22698 Incheon (KR)
(74) Representative: Hoffmann Eitle

(57) **Abstract**

A power module is provided. The power module includes a substrate, a power conversion chip that is disposed on the substrate and an insulating film that is formed on a structure in which the power conversion chip is disposed on the substrate. Additionally, the power module includes a metal mold that encases the structure that is coated with the insulating film. Additionally, the power module provides a simplified structure and improved heat dissipation performance compared to conventional power modules.

## Description

### BACKGROUND

### Field of the Invention

The present invention relates to a power module and a method of manufacturing the same, and more particularly, to a power module having a simplified structure and improved heat dissipation performance and a method of manufacturing the same.

### Description of the Related Art

A power converter or a power inverter included in a hybrid vehicle or an electrical vehicle is an important part of an eco-friendly vehicle. Recently, various technologies regarding a power converter have been developed. A power module is typically the most expensive portion of a power converter and is a required technology used in an eco-friendly vehicle. The power module development has focused on reduced production costs and improved cooling performance. For example, by improving cooling performance of a power module the rated normal current and chip size of a power semiconductor device is reduced which results in cost reductions and a more stable operation of a power module.

Conventionally, power modules include a structure that single-sided cooling or double-sided cooling is applied to have been produced. Additionally, conventional power modules have a structure that provides the substrate with a cooling water channel. Therefore, cooling occurs only from an exterior surface of the power module and heat within the interior of the power module is difficult to dissipate. In particular, since a power conversion chip of a power module, which is a heat generating element, is molded with an epoxy-type or gel-type sealing agent, heat resistance is increased due to the sealing agent. Accordingly, the power module has low heat dissipation performance. Further, when the sealing agent is injected and pressurized short-circuiting between conductive wires or disconnection of conductive wires form the electrical connection between power conversion chips or between a power conversion chip and a lead is likely to occur.

The foregoing is intended merely to aid in the understanding of the background of the present invention, and is not intended to mean that the present invention falls within the purview of the related art that is already known to those skilled in the art.

### SUMMARY

Accordingly, the present invention provides a power module with a simplified structure and improved heat dissipation performance and a method of manufacturing the same. In one aspect of the present invention, a power module may include a substrate, a power conversion chip disposed on the substrate, an insulating film formed on a structure in which the power conversion chip is disposed on the substrate and metal mold that encases the structure coated with the insulating film.

The power module may further include a lead that extends from an interior to an exterior of the metal mold and conductive wire electrically connected between a terminal of the power conversion chip and the lead. The insulating film may be formed on an exterior surface of the lead and an exterior surface of the conductive wire. The insulating film may be formed to cover the exterior surface of the lead disposed within the interior of the metal mold and a portion of the exterior surface of the lead disposed external to the metal mold may remain uncovered. The substrate may be a metal substrate. An exterior surface of the metal mold may have heat dissipation fins disposed thereon.

According to another aspect, a method of manufacturing a power module may include disposing a power conversion chip on a substrate, forming an insulating film on an exterior surface of a structure that the power conversion chip is disposed on the substrate and forming a metal mold to cover the structure coated with the insulating film through a molding process. The method may further include disposing a lead around the structure prior to the forming of the insulating film and connecting a terminal of the power conversion chip to the lead via a conductive wire before the forming of the insulating film, wherein the structure may further include the lead and the conductive wire.

The insulating film may be formed by exposing the structure to a liquefied insulating material. The metal mold may be formed having at least a portion of an exterior surface of a portion of the lead that remains uncovered to allow at least a portion of the lead to be exposed the exterior of the metal mold. The method may further include removing a portion of the insulating film formed on the exterior surface of the exposed portion of the lead disposed external to the metal mold after forming the metal mold. The metal mold may be formed through a casting process. For example, forming of the metal mold may include forming heat dissipation fins that protrude from an exterior surface of the metal mold.

The power module and the method of manufacturing the same according to the present invention may not include an epoxy-type or gel-type sealing agent, typically used for conventional power modules. Accordingly, production cost of the power module may be reduced. Additionally, since a high heat resistance area which is conventionally attributed to a sealing agent with poor heat conductivity may be removed the cooling performance of the power module may be improved. According to the power module and the method of manufacturing the same according to the present invention when a metal substrate with good heat conductivity is used instead of an insulating substrate such as an active metal brazing (AMB) substrate or a direct bonded copper (DBC) substrate the heat dissipation performance may be improved, raw material cost may be reduced and quality control and management may be improved.

In addition, according to the power module and the method of manufacturing the same since a metal mold having a complex form may be formed more easily a metal mold provided with heat dissipation fins on an exterior surface thereof may be formed and may significantly improve heat dissipation performance. Further, according to the power module and the method of manufacturing the same according to the present invention side surfaces that may include front, back, left, and a right surface and an upper and a lower surface of a metal mode may be used for heat dissipation. Accordingly, the heat dissipation performance may be improved in comparison with conventional power modules which dissipate heat from their one or two surfaces.

### BRIEF DESCRIPTION OF THE DRAWINGS

The above and other objects, features and other advantages of the present invention will be more clearly understood from the following detailed description when taken in conjunction with the accompanying drawings, in which:
FIG. 1 is an exemplary cross-sectional view illustrating a power module according to an exemplary embodiment of the present invention;
FIGS. 2 to 5 are exemplary cross-sectional views illustrating sequential process steps to manufacture a power module according to an exemplary embodiment of the present invention; and
FIG. 6 is an exemplary cross-sectional view illustrating a power module according to a modification of the exemplary embodiment of the present invention.

### DETAILED DESCRIPTION

Hereinafter, a power module according to one exemplary embodiment of the present invention and a method of manufacturing the same will be described with reference to the accompanying drawings to allow those skilled in the art to easily practice the present invention. Advantages and features of the present invention and methods for achieving the same will be clearly understood with reference to the following detailed description of exemplary embodiments in conjunction with the accompanying drawings. However, the present invention is not limited to the exemplary embodiments disclosed herein, but may be implemented in various different forms. The exemplary embodiments are merely given to make the disclosure of the present invention complete and to completely instruct the scope of the invention to those skilled in the art, and the present invention should be defined by the scope of the claims.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, in order to make the description of the present invention clear, unrelated parts are not shown and, the thicknesses of layers and regions are exaggerated for clarity. Further, when it is stated that a layer is "on" another layer or substrate, the layer may be directly on another layer or substrate or a third layer may be disposed therebetween.

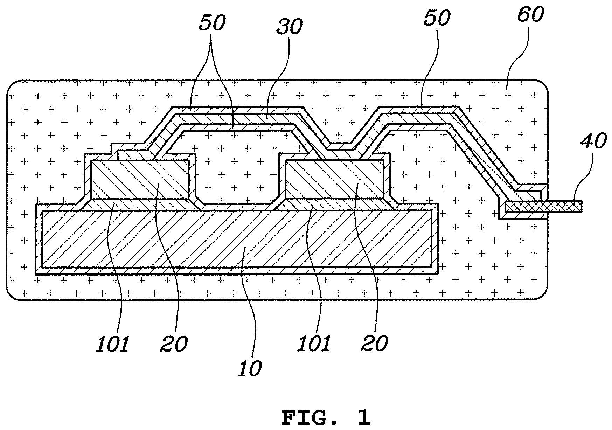

It is understood that the term "vehicle" or "vehicular" or other similar term as used herein is inclusive of motor vehicle in general such as passenger automobiles including sports utility vehicles (SUV), buses, trucks, various commercial vehicles, watercraft including a variety of boats, ships, aircraft, and the like and includes hybrid vehicles, electric vehicles, combustion, plug-in hybrid electric vehicles, hydrogen-powered vehicles and other alternative fuel vehicles (e.g. fuels derived from resources other than petroleum).FIG. 1 is an exemplary cross-sectional view illustrating a power module according to an exemplary embodiment of the present invention. As illustrated in FIG. 1, a power module according to an exemplary embodiment of the present invention may include a substrate 10, a power conversion chip 20 disposed on the substrate 10, an insulating film 50 formed on exterior surfaces of the substrate 10 and the power conversion chip 20 and a metal mold 60 in which the substrate 10 and the power conversion chip 20 coated with the insulating film 50 may be disposed to be molded together. In addition, the power module according to an exemplary embodiment may further include a lead 40 which extends from an interior to an exterior of the metal mold 60 and a conductive wire 30 that electrically connect a terminal of the power conversion chip 20 to the lead 40.

The substrate 10 may be a base that carries the power conversion chip 20 disposed on the surface thereof. In conventional power modules, an active metal brazing (AMB) substrate or a direct boded copper (DBC) substrate is used for the substrate 10. In particular, the exemplary embodiment may include an AMB substrate or a DBC substrate for the substrate 10. However, according to another exemplary embodiment, a metallic substrate may be used as the substrate 10. According to an exemplary embodiment of the present invention, the substrate 10 may be electrically insulated by the insulating film 50 to be described below. In particular, to ensure excellent heat dissipation performance, a metallic substrate which does not contain an insulating component such as ceramic or FRP which has heat conductivity that deteriorates may be used.

The power conversion chip 20 may be an electronic device disposed on the substrate 10 to enable an electrical current to flow for the purpose of power conversion. The power conversion chip 20 may be manufactured through semiconductor processes. For example, the power conversion chip 20 may include a switching element that may be a metal oxide semiconductor field effect transistor (MOSFET) or an insulated gate bipolar transistor (IGBT) and a diode may be coupled to the switching element. The power conversion chip 20 may be configured to perform rapid switching operations within a short cycle and may frequently transmit an electrical current that results in significant heat generation.

An upper surface and a lower surface of the power conversion chip 20 may include terminals for electrical connection. For example, as illustrated in FIG. 1, a terminal (not shown) formed on the lower surface of the power conversion chip 20 may be formed when the power conversion chip is electrically connected to the substrate 10 through solder joining or sinter joining or the like. As shown in FIG. 1, an adhesive 101 may be used to attach the lower terminal of the power conversion chip 20 to the substrate 10. According to the exemplary embodiment, when the substrate 10 is a metallic substrate, lower terminals of two power conversion chips 20 may be directly joined to the metallic substrate and the two power conversion chips 20 may be electrically connected to each other via the metallic substrate. The insulating film 50 may be formed on the exterior surface of the structure of the substrate 10 in which the power conversion chip 20 is disposed on. Due to the insulating film 50 formed on the surface of the structure of the substrate in which the power conversion chip 20 is disposed thereon, the structure may be electrically insulated from external environment.

According to the exemplary embodiment, the power module may further include the lead 40 and the conductive wire 30. The lead 40 may be an element to electrically connect the power module to an external device. The lead 40 may be a metal plate or a metal strip or similar connection configuration. The lead 40 may be disposed to extend from an interior to an exterior of the metal mold 60. In particular, within the metal mold 60, the lead 40 may be electrically connected to the power conversion chip 20 via the conductive wire 30. The conductive wire 30 may be an element for electrical connection disposed between the terminals formed on the surface of the power conversion chip 20 attached to the substrate 10 or may be disposed between the power conversion chip 20 and the lead 40. The conductive wire 30 may be formed of a conductive material such as a bonding wire or a conductive strip and may take various forms.

The exterior surfaces of the lead 40 and the conductive wire 30 may be covered with the insulating film when the lead 40 is electrically connected to the conductive wire 30. In other words, when the substrate 10, the power conversion chip 20, the conductive wire 30, and the lead 40, which are elements of the power module may be electrically connected to each other and may be electrically insulated from an external device due to the insulating film 50. The metal mold 60 that encases the substrate 10 and the power conversion chip 20 may be covered with the insulating film 50 and may allow the substrate 10 and the power conversion chip 20 to be molded into an integrated molded product. The metal mold 60 may be an electrically conductive member but may be electrically insulated from electronic components disposed within the interior thereof due to the insulating film 50. The metal mold 60 may be formed to accommodate the conductive wire 30 and a portion of the lead 40that may be covered with the insulating film 50 therein. In particular, the conductive wire 30 and the lead 40 may be electrically insulated from the metal mold 60 due to the insulating film 50. The metal mold 60 may be formed of a single-component metal (e.g., or a similar alloy thereof).

According to the exemplary embodiment, the metal mold 60 may be formed to cover a portion of the lead 40, for example, a contact portion may be disposed between the conductive wire 30 and the lead 40. The remaining portion of the lead 40 may be disposed external to the metal mold 60. At least a portion of the exposed portion of the lead 40 disposed external to the metal mold 60 may not be covered by the insulating film 50 to allow the power module to be electrically connected to an external device through the portion which is not covered by the insulating film 50. In other words, according to the exemplary embodiment an epoxy-type or a gel-type sealing agent conventionally used to package a power module may be eliminated from the process. Therefore, material cost of the power module may be reduced. Further, the power module according to the exemplary embodiment does not have a highly heat resistive region attributed to the sealing agent with power heat conductivity and thus, the power module may have an improved cooling performance. According to the exemplary embodiment, when a metal substrate is used instead of an AMB substrate, or a DBC substrate the heat transferability may be increased, material costs may be reduced and quality control and management may be improved.

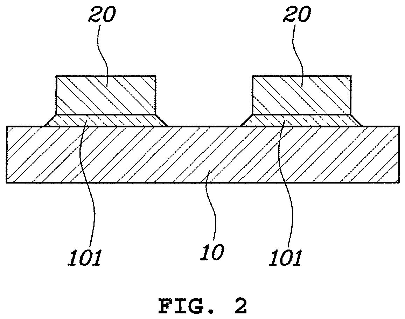

A method of manufacturing a power module according to another exemplary embodiment of the present invention will be described. FIGS. 2 to 5 are exemplary cross-sectional views illustrating sequential process steps to manufacture a power module according to an exemplary embodiment of the present invention. The method of manufacturing a power module according to the exemplary embodiment may include disposing a power conversion chip 20 on a substrate 10, as illustrated in FIG. 2. As having been described above, the power conversion chip 20 may be electrically connected to and physically coupled to the substrate 10 by solder joining or sinter joining or the like.

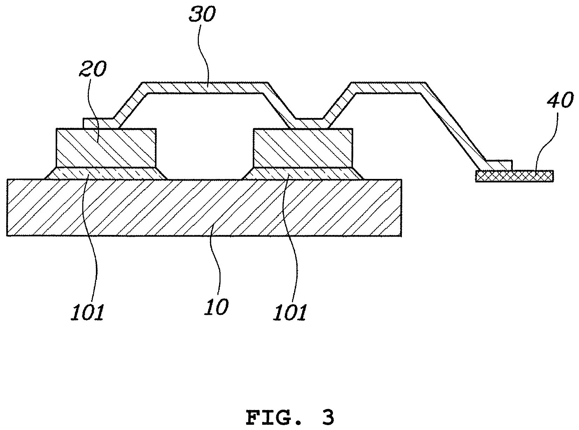

As illustrated in FIG. 3, a lead 40 that electrically connects a power module to an external device may be disposed at a periphery portion of the substrate 10 on which the power conversion chip 20 may be disposed. The power conversion chip 20 and the lead 40 may be electrically connected to each other via a conductive wire 30. According to an example illustrated in FIG. 3, the conductive wire 30 may be formed to couple a plurality of power conversion chips 20 to each other and couple an additional power conversion chip 20 to the lead 40. However, the conductive wire 30 may be disposed to connect the power conversion chips 20 to one another or may connect one power conversion chip to multiple leads.

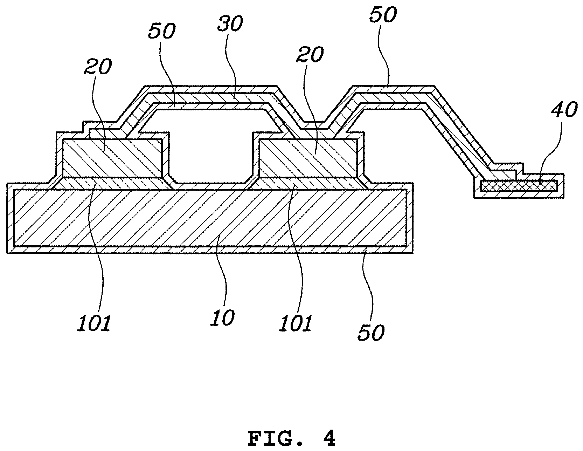

As illustrated in FIG. 4, an insulating film 50 may be formed on an exterior surface of a structure in which the substrate 10, the power conversion chip 20, the conductive wire 30, and the lead 40 which are elements of a power module disposed and coupled to each other. The forming of the insulating film 50 illustrated in FIG. 4 may include exposing the surface of the substrate in a liquefied insulating material the structure that may include the substrate 10, the power conversion chip 20, the conductive wire 30, and the lead 40, which are elements of a power module and ensuring that the elements of the structure are properly arranged and connected to enable the liquid insulating material to be adsorbed to the surface of the structure. When necessary a dry process or an intermediate process may be perfomed to enable the insulating material to be coated in a uniform thickness on the surface of the structure.

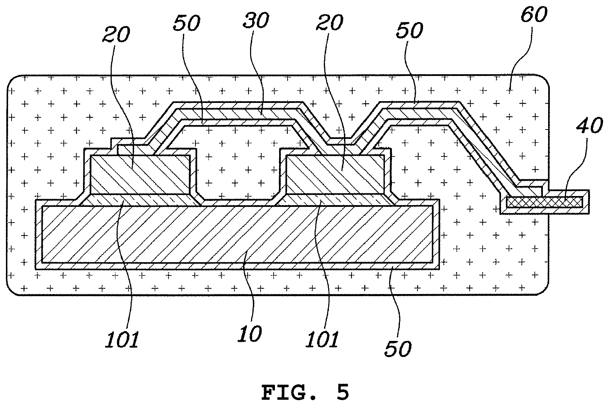

As illustrated in FIG 5, a metal mold may be formed to encase the structure coated with the insulating film 50. The metal mold 60 may be formed through a casting process. The metal mold 60 may be formed to be in contact with the surface of the insulating film 50 formed on the exterior surface of the substrate 10, the power conversion chip 20, the conductive wire 30, and the lead 40. Additionally, as illustrated in FIG. 5, the metal mold 60 may be formed to expose a portion of the lead 40 to an exterior to enable the lead 40 to be subsequently electrically connected to an external device.

Finally, the insulating film, which covers a portion of the lead 40 disposed external to the metal mold 60, may be partially removed. Accordingly, the power module illustrated in FIG. 1 may be completely formed. The portion of the lead 40 from which the insulating film may be removed a contact area to be electrically connected to an external device. Since the metal mold 60 may be manufactured through a casting process, various forms of metal molds 60 may be manufactured using a mold that has a different form in the casting process. For example, when heat is radiated from the surface of the metal mold 60, to improve the heat dissipation ability, the metal mold 60 may include a pin-fin area. In other words, the exterior surface of the metal mold 6 may include pin fins disposed thereon. In particular, a mold with pin fins may be used in a casting process to produce a metal mold with fins.

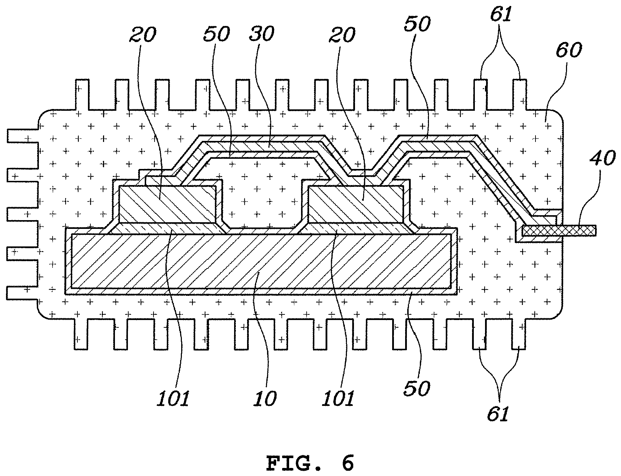

An example of the metal mold with fins is illustrated in FIG. 6. FIG. 6 is an exemplary cross-sectional view illustrating a power module according to a modification of an exemplary embodiment of the present invention. According to the modification illustrated in FIG. 6, the metal mold 60 may include heat dissipation fins 61 disposed on the surface thereof to increase an area to radiate heat and improves heat dissipation performance. However, the power module of FIG. 1, which is not equipped with heat dissipation fins has improved heat dissipation performance compared to conventional power modules by employing a metal mold. Furthermore, since various types of cooling devices may be disposed on other surfaces that may include side surfaces as well as upper and lower surfaces of a power module, the power module may have improved heat dissipation performance compared to conventional power module which dissipate heat from one or two surfaces thereof.

Although a an exemplary embodiment of the present invention has been described for illustrative purposes, those skilled in the art will appreciate that various modifications, additions and substitutions are possible, without departing from the scope and spirit of the present invention as disclosed in the accompanying claims.

## Claims

1. A power module, comprising:
a substrate;
a power conversion chip disposed on the substrate;
an insulating film formed on a structure in which the power conversion chip and the substrate are disposed; and
a metal mold encasing the structure coated with the insulating film.

2. The power module of claim 1, further comprising:
a lead extending from an interior to an exterior of the metal mold; and
a conductive wire electrically connected between a terminal of the power conversion chip and the lead.

3. The power module of claim 2, wherein the insulating film is formed on an exterior surface of the lead and an outer surface of the conductive wire.

4. The power module of claim 3, wherein the insulating film is formed to cover the exterior surface of the lead disposed within the interior of the metal mold and a portion of the exterior surface of the lead disposed external to the metal mold remains uncovered by the insulating film.

5. The power module of any one of the preceding claims, wherein the substrate is a metal substrate.

6. The power module of any one of the preceding claims, wherein heat dissipation fins are disposed on an exterior surface of the metal mold.

7. A method of manufacturing a power module, comprising:
disposing a power conversion chip on a substrate;
forming an insulating film on an exterior surface of a structure in which the power conversion chip and the substrate are disposed; and
forming a metal mold to cover the structure coated with the insulating film through a molding process.

8. The method of claim 7, further comprising:
disposing a lead around the structure before the forming of the insulating film; and
connecting a terminal of the power conversion chip to the lead via a conductive wire prior to forming the insulating film,
wherein the structure further includes the lead and the conductive wire.

9. The method of claim 7 or 8, wherein the forming of the insulating film includes exposing the structure to a liquefied insulating material.

10. The method of claim 9, wherein in the forming of the metal mold, t a portion of an exterior surface of a portion of the lead remains uncovered to expose at least a portion of the lead to an exterior of the metal mold.

11. The method of claim 10, further comprising removing a portion of the insulating film formed on the exterior surface of the exposed portion of the lead disposed external to the metal mold after the forming of the metal mold.

12. The method of any one of the claims 7 to 11, wherein the forming of the metal mold includes a casting process.

13. The method of any one of claims 7 to 12, wherein the forming of the metal mold includes forming heat dissipation fins protruding from an exterior surface of the metal mold.
